# FASCICULE DE BREVET EUROPEEN

(11) **EP 3 887 766 B1**
(45) Date de publication et mention de la délivrance du brevet: **07.06.2023**
(21) Numéro de dépôt: 19831792.7
(22) Date de dépôt: 20.11.2019
(51) Int. Cl.: G01D 5/245

(54) **MESURE D'UNE POSITION RELATIVE D'ELEMENTS MOBILES**
MESSUNG EINER RELATIVEN POSITION BEWEGLICHER TEILE
MEASUREMENT OF A RELATIVE POSITION OF MOVING PARTS

(30) Priorité: 29.11.2018 FR 1872039
(43) Date de publication de la demande: 06.10.2021
(73) Titulaire: Safran Electronics & Defense, 75015 Paris (FR)
(72) Inventeur: DAVID, Camille, 92100 BOULOGNE BILLANCOURT (FR)
(74) Mandataire: Plasseraud IP
(86) Numéro de dépôt international: PCT/FR2019/052769
(87) Numéro de publication internationale: WO 2020/109699

(56) Documents cités:
- FR-A1- 2 882 140
- US-A1- 2005 285 026
- US-A1- 2010 327 152

## Description

### Domaine technique

L'invention concerne la mesure d'une position relative de deux éléments mobiles.

### Technique antérieure

Caractériser avec une précision requise la position relative de deux éléments qui sont destinés se déplacer l'un par rapport à l'autre est un besoin courant. Notamment, un tel besoin de mesure existe souvent pour être effectué au sein d'un dispositif qui incorpore des éléments mobiles, sans accès depuis l'extérieur du dispositif, et parfois en plus pour que la mesure de position soit effectuée pendant un fonctionnement du dispositif. Tel est le cas au sein d'un dispositif optique lorsqu'il est nécessaire de connaître en temps réel la position d'un bloc de lentilles par rapport au reste du dispositif. Par exemple, des systèmes autofocus au sein de dispositifs imageurs nécessitent de connaître en temps réel la position de lentilles mobiles de mise au point, par rapport à une partie d'optique fixe ou par rapport à un capteur d'image.

Les exigences de précision de mesure varient entre des applications qui sont différentes. Toutefois, des précisions inférieures à 10 µm (micromètre) pour des courses de plusieurs millimètres sont souvent nécessaires. En outre, certaines applications nécessitent de répéter une même mesure à fréquence assez élevée, par exemple à plus de 1000 Hz (hertz), pour caractériser et/ou asservir la position relative des deux éléments qui sont mobiles l'un par rapport à l'autre avec suffisamment de précision. Une telle exigence peut exister lorsque l'un au moins des deux éléments peut être soumis à des vibrations, voire des chocs, et notamment lorsque le système de mesure de position est intégré au dispositif sans accès depuis l'extérieur.

De nombreux systèmes de mesure de position existent déjà, y compris des systèmes mécaniques, des systèmes optiques, tels que décrits notamment dans US 2005/285026, des systèmes à base d'éléments résistifs électriquement, etc. Toutefois, la plupart de ces systèmes de mesure ne sont pas compatibles avec une combinaison des exigences suivantes :
- un système de mesure qui soit peu encombrant et peu onéreux ;
- une précision de mesure qui soit inférieure à 10 µm ;
- un fonctionnement de mesure qui soit efficace en présence de vibrations ; et
- une résistance du système de mesure à des chocs.

Il existe notamment des ensembles de mesure de la position relative de deux éléments qui sont mobiles l'un par rapport à l'autre, tels que chaque ensemble de mesure comprend :
- un ruban, qui possède une extension longitudinale et qui comporte, parallèlement à cette extension longitudinale, une piste magnétique avec des pôles magnétiques dont des orientations individuelles de pôles sont fixes et alternées périodiquement le long de la piste, à partir d'une extrémité de cette piste ; et
- un premier capteur magnétique, qui est capable de détecter un passage de pôles magnétiques dont les orientations respectives sont différentes entre deux pôles successifs, devant une surface sensible de ce premier capteur lorsque le ruban est solidaire d'un premier des deux éléments et le premier capteur est solidaire de l'autre des deux éléments, la position étant mesurée à l'intérieur d'une période d'alternance des orientations des pôles magnétiques le long de la piste du ruban.

Mais un tel ensemble de mesure présente l'inconvénient de ne pas pouvoir différencier des positions des deux éléments l'un par rapport à l'autre, qui sont différentes d'un nombre entier de fois la période d'alternance des orientations des pôles magnétiques, parallèlement à l'extension longitudinale du ruban. Alors, en cas de choc qui impacte les deux éléments différemment l'un de l'autre, il est possible de perdre le comptage continu des alternances d'orientation des pôles magnétiques. Les mesures ultérieures présentent alors une incertitude qui est égale à un multiple de la période d'alternance de l'orientation des pôles magnétiques le long de la piste. Une procédure de réétalonnage de l'ensemble de mesure est alors nécessaire, avec un rappel en laboratoire du dispositif qui incorpore l'ensemble de mesure.

### Problème technique

A partir de cette situation, un but de la présente invention est de disposer de nouveaux ensembles de mesure de position, qui ne présentent pas les inconvénients cités précédemment, ou pour lesquels certains au moins de ces inconvénients sont réduits.

### Résumé de l'invention

Pour atteindre ce but ou un autre, un premier aspect de l'invention propose un nouvel ensemble de mesure d'une position relative de deux éléments mobiles l'un par rapport à l'autre, qui est du type à ruban et capteur magnétique comme indiqué plus haut. Mais selon l'invention, cet ensemble de mesure comprend en outre, en plus du premier capteur magnétique :
- un second capteur magnétique, qui est capable de détecter un passage d'au moins un pôle magnétique de l'extrémité de la piste magnétique du ruban, ou d'au moins deux pôles magnétiques successifs de ladite extrémité de la piste magnétique du ruban et dont les orientations respectives sont différentes, devant une surface sensible de ce second capteur lorsqu'il est solidaire du même des deux éléments que le premier capteur.

Ainsi, le second capteur magnétique est capable de détecter une position de l'extrémité de la piste magnétique, lorsque cette extrémité est amenée devant sa surface sensible. Une valeur de mesure est alors affectée à la position relative des deux éléments mobiles, qui correspond à cette mesure par le second capteur magnétique. Des positions ultérieures des deux éléments mobiles peuvent alors être mesurées en comptant continûment le défilement des alternances d'orientation des pôles magnétiques devant la surface sensible du premier capteur magnétique. Ainsi, le second capteur magnétique fournit une référence de mesure, aussi appelée origine des mesures, qui peut être retrouvée dès que nécessaire, par exemple après une vibration importante ou un choc susceptible de causer un saut dans la succession des alternances d'orientation des pôles magnétiques telle que détectée par le premier capteur magnétique. Le premier capteur magnétique reprend à chaque fois le comptage des alternances d'orientation de pôles magnétiques à partir de la dernière référence fournie par le second capteur magnétique. Autrement dit, le second capteur magnétique fournit une origine de mesure de position, qui est disponible *in situ* au sein du dispositif qui incorpore les deux éléments mobiles l'un par rapport à l'autre et l'ensemble de mesure de position conforme à l'invention. Ainsi, l'ensemble de l'invention permet d'obtenir des résultats de mesure absolue pour la position relative des deux éléments l'un par rapport à l'autre. Celui des deux éléments qui porte les deux capteurs magnétiques peut servir de référence de position, et la position de l'autre élément, qui porte le ruban, peut être mesurée de façon absolue par rapport à l'élément des deux capteurs.

Dans des modes possibles de réalisation de l'invention, le second capteur magnétique peut comprendre des moyens pour détecter une intensité d'un champ magnétique qui est créé par la piste magnétique du ruban dans ce second capteur. Alors, le second capteur est adapté pour détecter la position de l'extrémité de la piste magnétique du ruban, parallèlement à l'extension longitudinale de celui-ci, en comparant l'intensité du champ magnétique à au moins un seuil. Notamment, l'interruption de l'alternance des pôles magnétiques à l'extrémité de la piste magnétique du ruban provoque une réduction du champ magnétique qui est généré par le ruban dans le second capteur. C'est cette réduction qui est détectée par le second capteur magnétique, lorsque l'intensité du champ magnétique devient inférieure ou supérieure au seuil, selon le sens de passage de l'extrémité de la piste devant le second capteur magnétique. Le franchissement du seuil permet ainsi de définir un pôle magnétique de référence qui est lié au ruban, et à partir duquel le passage des pôles magnétiques est compté continûment pour obtenir la mesure absolue de position.

Dans des modes préférés de réalisation de l'invention, l'une au moins des caractéristiques additionnelles suivantes peut être reproduite optionnellement, seule ou en combinaison de plusieurs d'entre elles :
- le second capteur magnétique peut être adapté pour déterminer une position de l'extrémité de la piste magnétique du ruban, parallèlement à l'extension longitudinale du ruban, avec une incertitude qui est inférieure à une demi-période de l'alternance des orientations des pôles magnétiques le long de la piste du ruban ;
- la période d'alternance des orientations des pôles magnétiques le long de la piste du ruban peut être inférieure ou égale à 2,5 mm, par exemple égale à 2 mm ;
- le premier capteur magnétique peut être adapté pour déterminer une position d'un segment de la piste magnétique du ruban, parallèlement à l'extension longitudinale de ce ruban, avec une incertitude qui est inférieure à 10 µm, de préférence inférieure à 5 µm, à l'intérieur de la période de l'alternance des orientations des pôles magnétiques le long de la piste du ruban ;
- le premier capteur magnétique peut être adapté pour mesurer une position des pôles magnétiques devant sa surface sensible, à l'intérieur de la période de l'alternance des orientations des pôles magnétiques le long de la piste du ruban, à une fréquence qui est supérieure à 3000 Hz, de préférence supérieure ou égale à 4000 Hz ; et
- les premier et second capteurs magnétiques peuvent être identiques, le premier capteur étant disposé au sein de l'ensemble de mesure pour fonctionner en mode linéaire afin de mesurer la position des pôles magnétiques devant sa surface sensible à l'intérieur de la période de l'alternance des orientations des pôles magnétiques le long de la piste du ruban, et le second capteur étant disposé au sein de l'ensemble de mesure pour fonctionner en mode non-linéaire afin de détecter le passage devant la surface sensible de ce second capteur, d'au moins un pôle magnétique de l'extrémité de la piste magnétique du ruban, ou d'au moins deux pôles magnétiques successifs de cette extrémité de la piste magnétique du ruban et dont les orientations respectives sont différentes.

En particulier, la possibilité pour le premier capteur magnétique d'effectuer des mesures de position des pôles magnétiques du ruban à une fréquence qui est suffisamment élevée, permet de suivre des déplacements des deux éléments l'un par rapport à l'autre qui sont rapides, voire très rapides. En effet, un suivi continuel ou quasi-continuel du déplacement des deux éléments l'un par rapport à l'autre est ainsi possible, ce qui permet de ne pas manquer le passage d'une alternance de pôles devant le premier capteur magnétique entre deux mesures successives. Il n'est alors pas nécessaire de procéder à un nouveau passage de l'extrémité de la piste magnétique du ruban devant le second capteur magnétique pour recaler l'origine des mesures de position par rapport à l'extrémité du ruban. De tels déplacements rapides ou très rapides des deux éléments l'un par rapport à l'autre peuvent être causés par des chocs, notamment.

Un second aspect de l'invention propose un procédé de mesure d'une position relative de deux éléments, ce procédé comprenant les étapes suivantes :
- fixer sur le second des deux éléments, le premier capteur magnétique d'un ensemble de mesure qui est conforme au premier aspect de l'invention ;
- fixer le ruban de l'ensemble de mesure sur le premier des deux éléments, de sorte que le ruban défile continûment devant la surface sensible du premier capteur lorsque les deux éléments sont mobiles l'un par rapport à l'autre, avec une composante de déplacement relatif des deux éléments au niveau du ruban qui n'est pas perpendiculaire à l'extension longitudinale du ruban ; et
- fixer le second capteur magnétique sur le second élément, en plus du premier capteur, de sorte qu'il existe au moins une position relative des deux éléments, pour laquelle la surface sensible du second capteur magnétique est en face de l'extrémité de la piste magnétique du ruban, et pour laquelle la surface sensible du premier capteur magnétique est simultanément en face d'une partie de la piste magnétique du ruban, distante de son extrémité.

L'invention peut être avantageusement utilisée dans des applications où l'un des deux éléments comprend un bloc mobile à une ou plusieurs lentille(s) optique(s), et l'autre des deux éléments comprend une monture servant de support au bloc mobile à lentille(s). Les deux éléments et l'ensemble de mesure peuvent alors appartenir à un dispositif optique.

Dans d'autres applications possibles de l'invention, l'un des deux éléments peut comprendre un contrepoids mobile, et l'autre des deux éléments peut comprendre une monture servant de support au contrepoids mobile. Les deux éléments et l'ensemble de mesure peuvent alors appartenir à un dispositif d'équilibrage dynamique.

### Brève description des dessins

Les caractéristiques et avantages de la présente invention apparaîtront plus clairement dans la description détaillée ci-après d'un exemple de réalisation non-limitatif, en référence à l'unique figure suivante qui est annexée :

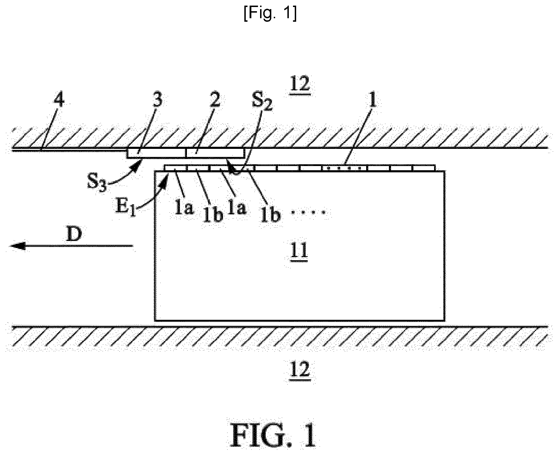

[Fig. 1] est une vue en coupe longitudinale d'un dispositif à deux éléments mobiles qui incorpore un ensemble de mesure de position conforme à l'invention.

### Description détaillée de l'invention

Pour raison de clarté, les dimensions des éléments qui sont représentés dans cette figure ne correspondent ni à des dimensions réelles, ni à des rapports de dimensions réels. En outre, certains de ces éléments ne sont représentés que symboliquement.

Dans [Fig. 1], la référence 11 désigne un bloc mobile et la référence 12 désigne une monture. La monture 12 possède une fonction de support pour le bloc 11, et est telle que le bloc 11 puisse se déplacer par rapport à la monture 12. Possiblement, la monture 12 peut posséder en outre une fonction de guidage du déplacement du bloc 11, mais cette fonction de guidage peut alternativement être produite par d'autres éléments non-représentés. Ainsi, le bloc 11 peut se déplacer par translation selon la flèche D par rapport à la monture 12, par exemple à partir de la position relative des deux éléments 11 et 12 telle que représentée dans la figure. Un système de mise en mouvement et d'entraînement du bloc 11, non-représenté, permet de produire son déplacement par rapport à la monture 12. A titre d'illustration non-limitative, le bloc 11 peut comprendre au moins une lentille optique, ou un contrepoids en fonction de l'application de l'invention.

L'ensemble de mesure de la position du bloc 11 par rapport à la monture 12 comprend un ruban à piste magnétique 1, un premier capteur magnétique 2 et un second capteur magnétique 3. Eventuellement, une liaison 4 de communication par signaux électriques peut relier les deux capteurs 2 et 3 à un contrôleur non-représenté. La liaison 4 peut aussi assurer l'alimentation électrique des capteurs 2 et 3. Alternativement, les deux capteurs 2 et 3 peuvent être adaptés pour transmettre des signaux de mesure par un système de communication sans fil.

Le ruban à piste magnétique 1 est fixé sur le bloc 11, et disposé parallèlement à la direction du déplacement D. Il comporte une piste magnétique qui est constituée d'un alignement, parallèle à la direction D, de dipôles magnétiques qui sont orientés alternativement selon deux directions différentes. Par exemple, les dipôles magnétiques 1a et 1b ont leurs axes nord-sud orientés perpendiculairement au ruban 1, c'est-à-dire perpendiculairement à la surface du bloc 11 sur laquelle le ruban 1 est collé à plat. Dans ce cas, les dipôles magnétiques 1a peuvent avoir leurs pôles nord tournés vers l'extérieur du bloc 11, et les dipôles magnétiques 1b peuvent avoir leurs pôles nord tournés à l'opposé, c'est-à-dire vers l'intérieur du bloc 11. D'autres orientations des dipôles magnétiques 1a et 1b sont aussi possibles, par exemple avec leurs axes nord-sud qui sont parallèles à la surface du bloc 11 sur laquelle le ruban 1 est collé à plat, mais encore inversés entre deux dipôles magnétiques qui sont successifs selon la direction D. La période des dipôles 1a et 1b, en tenant compte de leurs orientations alternées, peut être de 2 mm (millimètre) par exemple. Des matériaux adaptés pour constituer une telle piste magnétique du ruban 1 sont connus de l'Homme du métier, notamment à base de composés de terres rares.

Par exemple, la piste magnétique du ruban 1 peut avoir une longueur qui est comprise entre 4 mm (millimètre) et 50 mm, et une largeur de l'ordre de 10 mm. Notamment, la piste magnétique du ruban 1 peut avoir une longueur qui est égale à la longueur de course utile du déplacement du bloc 11 par rapport à la monture 12, augmentée d'une marge, par exemple de 3 mm, afin de garantir une linéarité des mesures sur toute la course utile de déplacement.

Les deux capteurs magnétiques 2 et 3 peuvent être identiques, avec des modes de fonctionnement sélectionnés pour chacun d'eux qui sont différents. Ils comportent chacun une surface sensible, S₂ pour le capteur 2 et S₃ pour le capteur 3, à disposer en vis-à-vis de la piste magnétique du ruban 1, par exemple à 0,2 mm de celle-ci. La surface sensible de chaque capteur peut être constituée d'un ou plusieurs récepteur(s) magnétique(s) séparé(s), par exemple du type récepteur à effet Hall. Chaque récepteur perçoit l'orientation de celui ou ceux des dipôles magnétiques du ruban 1 qui est (sont) juste en vis-à-vis de lui. Il délivre alors un signal de mesure qui caractérise une position, par rapport à ce récepteur et selon la direction D, d'un motif de deux dipôles magnétiques successifs. Par exemple, un tel motif magnétique peut être un dipôle 1a qui est contigu avec et juste à gauche d'un dipôle 1b. Il est noté 1a-1b dans la suite. La longueur, selon la direction D, de la surface sensible S₂ (respectivement S₃) du capteur 2 (resp. 3) est en général supérieure ou égale à la période, aussi selon la direction D, d'alternance d'orientation des dipôles magnétiques. De préférence, elle peut être égale à un multiple de cette période, par exemple égale à son triple. Dans ces conditions, des capteurs magnétiques qui sont disponibles commercialement ont une précision de mesure de la position du motif magnétique 1a-1b de 5 µm, par rapport à un point central de chaque surface sensible de capteur. Par exemple, la position du motif magnétique 1a-1b peut être codée numériquement entre -2048 et +2047. Le capteur magnétique 2, dit «codeur de position», est utilisé selon ce mode de fonctionnement, dit linéaire.

Le capteur magnétique 3, dit «codeur d'origine», peut être utilisé selon un mode de fonctionnement différent, dit non-linéaire et destiné à identifier une position d'un premier dipôle magnétique ou d'un premier motif magnétique à l'extrémité E₁ de la piste du ruban 1, devant sa surface sensible S₃. Le capteur magnétique 3 détermine alors la position de l'extrémité E₁ du ruban 1 d'après la position d'un front de champ magnétique asymétrique, par exemple encore par rapport au point central de sa surface sensible S₃. Une méthode de mesure par comparaison d'une amplitude détectée avec un seuil fixe, peut être utilisée pour cela. Dans un mode alternatif de fonctionnement du capteur magnétique 3, l'extrémité E₁ de la piste magnétique du ruban 1 peut être détectée par le capteur magnétique 3 en mesurant une valeur moyenne d'un champ magnétique, ou une amplitude d'une composante de Fourier du champ magnétique par rapport à une coordonnée spatiale parallèle à la direction D, tel que ce champ magnétique est généré par la piste magnétique dans le capteur magnétique 3. Une décroissance de cette valeur moyenne ou amplitude mesurée en dessous d'un seuil fixe, ou un dépassement du seuil par la valeur moyenne ou amplitude mesurée, caractérise le passage de l'extrémité E₁ de la piste magnétique du ruban 1 à un point identifié du capteur magnétique 3. La précision de telles mesures de position de l'extrémité E₁, pour les modes de fonctionnement décrits pour le capteur magnétique 3, est moins fine de celle du mode de fonctionnement du capteur magnétique 2. Cependant, elle est inférieure à la demi-période, parallèlement à la direction D, de l'alternance d'orientation des dipôles 1a et 1b. Ainsi, le capteur magnétique 3 permet de lever une indétermination quant auquel des motifs magnétiques successifs 1a-1b se trouve devant la surface sensible S₂ du capteur magnétique 2 lorsque l'extrémité E₁ de la piste du ruban 1 est simultanément devant la surface sensible S₃ du capteur magnétique 3. Par exemple, la précision du capteur magnétique 3 pour déterminer la position de l'extrémité E₁ du ruban 1 peut n'être que de 40 µm ou plus. Lorsque le bloc 11 est déplacé selon la flèche D de sorte que l'extrémité E₁ de la piste du ruban 1 n'est plus en face de la surface sensible S₃ du capteur magnétique 3, la position du ruban 1 est déterminée en comptant, pendant le déplacement, les périodes de variation du signal de mesure qui est délivré par le capteur magnétique 2. Ces périodes sont associées au défilement de motifs magnétiques 1a-1b successifs, complets puis partiel. La précision d'un tel mode de mesure est alors procurée par le mode de fonctionnement linéaire du capteur magnétique 2. Il n'est donc pas nécessaire que les capteurs 2 et 3 soient positionnés précisément l'un par rapport à l'autre selon la direction D, tant que cette précision est inférieure à la période d'alternance d'orientation des dipôles magnétiques.

Cette précision de mesure, qui est procurée par le capteur magnétique 2, est obtenue pour des positions quelconques du bloc 11 par rapport à la monture 12 tant que la surface sensible S₂ du capteur magnétique 2 reste entièrement en vis-à-vis d'une partie du ruban 1. Autrement dit, il est nécessaire pour cela que le ruban 1 ait une portion de longueur utile qui reste constamment en vis-à-vis de la surface sensible S₂ du capteur magnétique 2, et que le capteur magnétique 3 soit décalé selon la direction D par rapport au capteur magnétique 2 de sorte qu'un déplacement du bloc 11 permette d'amener l'extrémité E₁ de la piste du ruban 1 en vis-à-vis du capteur magnétique 3.

Des modèles de capteurs magnétiques sont disponibles commercialement, qui permettent d'effectuer des mesures à une fréquence comprise entre 100 Hz et 5000 Hz. Des mesures qui sont réalisées à une fréquence supérieure à 3000 Hz, par exemple à au moins 4000 Hz, permettent de suivre dans le temps - ou résoudre temporellement, dans le jargon de l'Homme du métier - des chocs susceptibles d'être subis par le bloc 11 et qui produiraient des décalages soudains de celui-ci par rapport à la monture 12.

Toutefois, en cas de choc trop rapide ou pour toute autre raison qui nécessiterait de recompter les motifs qui ont déjà défilé devant la surface sensible S₂ du capteur magnétique 2 à partir d'une position où l'extrémité E₁ de la piste du ruban 1 est devant la surface sensible S₃ du capteur magnétique 3, il suffit de commander un déplacement du bloc 11 jusqu'à ce que l'extrémité E₁ de la piste du ruban 1 passe de nouveau devant la surface sensible S₃ du capteur magnétique 3. Le comptage de défilement des motifs magnétiques 1a-1b est alors repris à son début à partir du moment où la position de l'extrémité E₁ est déterminée par le capteur magnétique 3. Mais lorsque l'éventualité d'un choc très rapide est prévisible, il peut être préférable d'augmenter la fréquence de mesure du capteur magnétique 2 pour résoudre encore ce choc temporellement, et ainsi éviter une durée consacrée à un recomptage des motifs magnétiques 1a-1b à partir de l'extrémité E₁ de la piste du ruban 1.

Il est entendu que l'invention peut être reproduite en modifiant des aspects secondaires du mode de réalisation qui a été décrit en détail ci-dessus, tout en conservant certains au moins des avantages cités. Notamment, les deux capteurs magnétiques peuvent être disposés côte-à-côte ou espacés l'un de l'autre selon la direction de déplacement D. Toutefois, ils peuvent être de préférence côte-à-côte pour réduire une longueur totale du ruban 1, et diminuer un encombrement de l'ensemble de mesure de position au sein du dispositif qui comprend le bloc 11, la monture 12 et cet ensemble de mesure de position.

Enfin, bien que la description ait pris pour exemple de fixer le ruban 1 sur le bloc mobile 11 et les deux capteurs magnétiques 2 et 3 sur la monture 12, l'inverse peut être envisagé de façon équivalente.

## Revendications

1. Ensemble de mesure d'une position relative de deux éléments (11, 12) mobiles l'un par rapport à l'autre, ledit ensemble comprenant :
- un ruban (1), qui possède une extension longitudinale et qui comporte, parallèlement à cette extension longitudinale, une piste magnétique avec des pôles magnétiques (1a, 1b) dont des orientations individuelles de pôles sont fixes et alternées périodiquement le long de la piste, à partir d'une extrémité (E₁) de ladite piste ; et
- un premier capteur magnétique (2), qui est capable de mesurer une position de pôles magnétiques (1a, 1b) dont les orientations respectives sont différentes entre deux pôles successifs, devant une surface sensible (S₂) du premier capteur lorsque le ruban (1) est solidaire d'un premier (11) des deux éléments et le premier capteur est solidaire de l'autre (12) desdits deux éléments, la position étant mesurée à l'intérieur d'une période d'alternance des orientations des pôles magnétiques le long de la piste du ruban ;
l'ensemble étant **caractérisé en ce qu'**il comprend en outre :
- un second capteur magnétique (3), qui est capable de détecter un passage d'au moins un pôle magnétique de l'extrémité (E₁) de la piste magnétique du ruban (1), ou d'au moins deux pôles magnétiques successifs de ladite extrémité de la piste magnétique du ruban et dont les orientations respectives sont différentes, devant une surface sensible (S₃) du second capteur, lorsque ledit second capteur magnétique est solidaire dudit autre (12) des deux éléments avec ledit premier capteur (2).

2. Ensemble de mesure selon la revendication 1, dans lequel le second capteur (3) est adapté pour déterminer une position de l'extrémité (E₁) de la piste magnétique du ruban (1), parallèlement à l'extension longitudinale dudit ruban, avec une incertitude qui est inférieure à une demi-période d'alternance des orientations des pôles magnétiques le long de la piste dudit ruban.

3. Ensemble de mesure selon la revendication 1 ou 2, dans lequel le second capteur magnétique (3) comprend des moyens pour détecter une intensité d'un champ magnétique qui est créé par la piste magnétique du ruban (1) dans ledit second capteur, et ledit second capteur est adapté pour détecter la position de l'extrémité (E₁) de la piste magnétique du ruban (1), parallèlement à l'extension longitudinale dudit ruban, en comparant l'intensité du champ magnétique à au moins un seuil.

4. Ensemble de mesure selon l'une quelconque des revendications précédentes, dans lequel la période d'alternance des orientations des pôles magnétiques le long de la piste du ruban (1) est inférieure ou égale à 2,5 mm.

5. Ensemble de mesure selon l'une quelconque des revendications précédentes, dans lequel le premier capteur magnétique (2) est adapté pour déterminer une position d'un segment de la piste magnétique du ruban (1), parallèlement à l'extension longitudinale dudit ruban, avec une incertitude qui est inférieure à 10 µm, de préférence inférieure à 5 µm, à l'intérieur d'une période de l'alternance des orientations des pôles magnétiques le long de ladite piste du ruban.

6. Ensemble de mesure selon l'une quelconque des revendications précédentes, dans lequel le premier capteur magnétique (2) est adapté pour mesurer une position des pôles magnétiques devant la surface sensible (S₂) dudit premier capteur, à l'intérieur d'une période de l'alternance des orientations des pôles magnétiques le long de la piste du ruban (1), à une fréquence supérieure à 3000 Hz, de préférence supérieure ou égale à 4000 Hz.

7. Procédé de mesure d'une position relative de deux éléments (11, 12), ledit procédé comprenant les étapes suivantes :
- fixer sur un second (12) des deux éléments, un premier capteur magnétique (2) d'un ensemble de mesure qui est conforme à l'une quelconque des revendications 1 à 6 ;
- fixer le ruban (1) de l'ensemble de mesure sur un premier (11) des deux éléments, de sorte que le ruban défile continûment devant la surface sensible (S₂) du premier capteur (2) lorsque les deux éléments (11, 12) sont mobiles l'un par rapport à l'autre, avec une composante de déplacement relatif des deux éléments au niveau du ruban qui n'est pas perpendiculaire à l'extension longitudinale dudit ruban ; et
- fixer le second capteur magnétique (3) sur le second élément (12), en plus dudit premier capteur (2), de sorte qu'il existe au moins une position relative des deux éléments (11, 12), pour laquelle la surface sensible (S₃) du second capteur magnétique est en face de l'extrémité (E₁) de la piste magnétique du ruban (1), et pour laquelle la surface sensible (S₂) du premier capteur magnétique est simultanément en face d'une partie de la piste magnétique du ruban, qui est distante de l'extrémité (E₁) de piste magnétique.

8. Procédé selon la revendication 7, suivant lequel l'un des deux éléments (11, 12) comprend un bloc mobile à au moins une lentille optique, et l'autre des deux éléments comprend une monture servant de support audit bloc mobile, les deux éléments et l'ensemble de mesure appartenant à un dispositif optique.

9. Procédé selon la revendication 7, suivant lequel l'un des deux éléments (11, 12) comprend un contrepoids mobile, et l'autre des deux éléments comprend une monture servant de support au contrepoids mobile, les deux éléments et l'ensemble de mesure appartenant à un dispositif d'équilibrage dynamique.

## Patentansprüche

1. Messanordnung zum Messen einer relativen Position von zwei relativ zueinander beweglichen Elementen (11, 12), wobei die Anordnung enthält:
- ein Band (1), das eine Längsausdehnung besitzt und parallel zu dieser Längsausdehnung einen Magnetstreifen mit Magnetpolen (1a, 1b) aufweist, deren einzelne Polausrichtungen fest sind und sich entlang des Streifens ausgehend von einem Endabschnitt (E₁) des Streifens periodisch abwechseln; und
- einen ersten Magnetsensor (2), der in der Lage ist, eine Position von Magnetpolen (1a, 1b), deren jeweilige Ausrichtungen zwischen zwei aufeinanderfolgenden Polen unterschiedlich sind, vor einer sensitiven Oberfläche (S₂) des ersten Sensors zu messen, wenn das Band (1) mit einem (11) der beiden Elemente fest verbunden ist und der erste Sensor mit dem anderen (12) der beiden Elemente fest verbunden ist, wobei die Position innerhalb einer Periode der Wechselfolge von Magnetpolausrichtungen entlang des Bandstreifens gemessen wird;
wobei die Anordnung **dadurch gekennzeichnet ist, dass** sie ferner enthält:
- einen zweiten Magnetsensor (3), der in der Lage ist, ein Passieren von zumindest einem Magnetpol des Endabschnitts (E₁) des Magnetstreifens des Bandes (1) oder von zumindest zwei aufeinanderfolgenden Magnetpolen des Endabschnitts des Magnetstreifens des Bandes, deren jeweilige Ausrichtungen unterschiedlich sind, vor einer sensitiven Oberfläche (S₃) des zweiten Sensors zu erfassen, wenn der zweite Magnetsensor mit dem anderen (12) der beiden Elemente, das mit dem ersten Sensor (2) verbunden ist, fest verbunden ist.

2. Messanordnung nach Anspruch 1,
wobei der zweite Sensor (3) dazu ausgelegt ist, eine Position des Endabschnitts (E₁) des Magnetstreifens des Bandes (1) parallel zur Längsausdehnung des Bandes mit einer Unsicherheit zu bestimmen, die kleiner ist als eine halbe Periode der Wechselfolge von Magnetpolausrichtungen entlang der Bandstreifens.

3. Messanordnung nach Anspruch 1 oder 2,
wobei der zweite Magnetsensor (3) Mittel zum Erfassen einer Magnetfeldstärke umfasst, die von dem Magnetstreifen des Bandes (1) in dem zweiten Sensor erzeugt wird, und wobei der zweite Sensor dazu ausgelegt ist, die Position des Endabschnitts (E₁) des Magnetstreifens des Bandes (1) parallel zur Längsausdehnung des Bandes durch Vergleichen der Magnetfeldstärke mit zumindest einem Schwellenwert zu erfassen.

4. Messanordnung nach einem der vorhergehenden Ansprüche,
wobei die Periode der Wechselfolge von Magnetpolausrichtungen entlang des Streifens des Bandes (1) kleiner oder gleich 2,5 mm ist.

5. Messanordnung nach einem der vorhergehenden Ansprüche,
wobei der erste Magnetsensor (2) dazu ausgelegt ist, eine Position eines Segments des Magnetstreifens des Bandes (1) parallel zur Längsausdehnung des Bandes mit einer Unsicherheit zu bestimmen, die innerhalb einer Periode der Wechselfolge von Magnetpolausrichtungen entlang des Bandstreifens kleiner als 10 µm, vorzugsweise kleiner als 5 µm, ist.

6. Messanordnung nach einem der vorhergehenden Ansprüche,
wobei der erste Magnetsensor (2) dazu ausgelegt ist, eine Position der Magnetpole vor der sensitiven Oberfläche (S₂) des ersten Sensors innerhalb einer Periode der Wechselfolge von Magnetpolausrichtungen entlang des Streifens des Bandes (1) bei einer Frequenz höher als 3000 Hz, vorzugsweise höher oder gleich 4000 Hz, zu messen.

7. Verfahren zum Messen einer relativen Position von zwei Elementen (11, 12), wobei das Verfahren die folgenden Schritte umfasst:
- Befestigen eines ersten Magnetsensors (2) einer Messanordnung nach einem der Ansprüche 1 bis 6 an einem zweiten (12) der beiden Elemente;
- Befestigen des Bandes (1) der Messanordnung an einem ersten (11) der beiden Elemente, so dass das Band kontinuierlich an der sensitiven Oberfläche (S₂) des ersten Sensors (2) vorbeiläuft, wenn die beiden Elemente (11, 12) mit einer Komponente der relativen Verschiebung der beiden Elemente an dem Band, die nicht senkrecht zur Längsausdehnung des Bandes ist, relativ zueinander beweglich sind; und
- Befestigen des zweiten Magnetsensors (3) an dem zweiten Element (12) zusätzlich zu dem ersten Sensor (2), so dass zumindest eine relative Position der beiden Elemente (11, 12) besteht, bei der die sensitive Oberfläche (S₃) des zweiten Magnetsensors dem Endabschnitt (E₁) des Magnetstreifens des Bandes (1) gegenüberliegt und bei der die sensitive Oberfläche (S₂) des ersten Magnetsensors zugleich einem Abschnitt des Magnetstreifens des Bandes gegenüberliegt, der von dem Endabschnitt (E₁) des Magnetstreifens beabstandet ist.

8. Verfahren nach Anspruch 7,
wobei eines der beiden Elemente (11, 12) einen beweglichen Block mit zumindest einer optischen Linse umfasst und das andere der beiden Elemente eine Halterung umfasst, die als Stütze für den beweglichen Block dient, wobei die beiden Elemente und die Messanordnung zu einer optischen Vorrichtung gehören.

9. Verfahren nach Anspruch 7,
wobei eines der beiden Elemente (11, 12) ein bewegliches Gegengewicht umfasst und das andere der beiden Elemente eine Halterung umfasst, die als Stütze für das bewegliche Gegengewicht dient, wobei die beiden Elemente und die Messanordnung zu einer dynamischen Ausgleichsvorrichtung gehören.

## Claims

1. An assembly for measuring a relative position of two elements (11, 12) that are movable with respect to one another, said assembly comprising:
- a ribbon (1), which has a longitudinal extension and which comprises, parallel to this longitudinal extension, a magnetic strip with magnetic poles (1a, 1b) in which the individual orientations of the poles are fixed and alternated periodically along the strip, from one end (E₁) of said strip; and
- a first magnetic sensor (2), which is capable of measuring a position of magnetic poles (1a, 1b) whose respective orientations are different between two successive poles, in front of a sensitive surface (S₂) of the first sensor when the ribbon (1) is secured to a first (11) of the two elements and the first sensor is secured to the other (12) of said two elements, the position being measured within a period of alternation of the orientations of the magnetic poles along the strip of the ribbon;
the assembly being **characterized in that** it further comprises:
- a second magnetic sensor (3), which is capable of detecting a passage of at least one magnetic pole of the end (E₁) of the magnetic strip of the ribbon (1), or of at least two successive magnetic poles of said end of the magnetic strip of the ribbon and whose respective orientations are different, in front of a sensitive surface (S₃) of the second sensor, when said second magnetic sensor is secured to said other (12) of the two elements with said first sensor (2).

2. The measurement assembly as claimed in claim 1, wherein the second sensor (3) is suitable for determining a position of the end (E₁) of the magnetic strip of the ribbon (1), parallel to the longitudinal extension of said ribbon, with an uncertainty which is less than a half period of alternation of the orientations of the magnetic poles along the strip of said ribbon.

3. The measurement assembly as claimed in claim 1 or 2, wherein the second magnetic sensor (3) comprises means for detecting an intensity of a magnetic field which is created by the magnetic strip of the ribbon (1) in said second sensor, and said second sensor is suitable for detecting the position of the end (E₁) of the magnetic strip of the ribbon (1), parallel to the longitudinal extension of said ribbon, by comparing the intensity of the magnetic field to at least one threshold.

4. The measurement assembly as claimed in any one of the preceding claims, wherein the period of alternation of the orientations of the magnetic poles along the strip of the ribbon (1) is less than or equal to 2.5 mm.

5. The measurement assembly as claimed in any one of the preceding claims, wherein the first magnetic sensor (2) is suitable for determining a position of a segment of the magnetic strip of the ribbon (1), parallel to the longitudinal extension of said ribbon, with an uncertainty which is less than 10 µm, preferably less than 5 µm, within a period of alternation of the orientations of the magnetic poles along said strip of the ribbon.

6. The measurement assembly as claimed in any one of the preceding claims, wherein the first magnetic sensor (2) is suitable for measuring a position of the magnetic poles in front of the sensitive surface (S₂) of said first sensor, within a period of alternation of the orientations of the magnetic poles along the strip of the ribbon (1), at a frequency greater than 3000Hz, preferably greater than or equal to 4000Hz.

7. A method for measuring a relative position of two elements (11, 12), said method comprising the following steps:
- fixing, onto a second (12) of the two elements, a first magnetic sensor (2) of a measurement assembly which is in accordance with any one of claims 1 to 6;
- fixing the ribbon (1) of the measurement assembly onto a first (11) of the two elements, such that the ribbon runs continuously in front of the sensitive surface (S₂) of the first sensor (2) when the two elements (11, 12) are movable with respect to one another, with a component of relative displacement of the two elements at the ribbon level which is not at right angles to the longitudinal extension of said ribbon; and
- fixing the second magnetic sensor (3) onto the second element (12), in addition to said first sensor (2), such that there is at least one relative position of the two elements (11, 12) for which the sensitive surface (S₃) of the second magnetic sensor is facing the end (E₁) of the magnetic strip of the ribbon (1), and for which the sensitive surface (S₂) of the first magnetic sensor is simultaneously facing a part of the magnetic strip of the ribbon, which is away from the end (E₁) of the magnetic strip.

8. The method as claimed in claim 7, whereby one of the two elements (11, 12) comprises a movable block with at least one optical lens, and the other of the two elements comprises a mount serving as support for said movable block, the two elements and the measurement assembly belonging to an optical device.

9. The method as claimed in claim 7, whereby one of the two elements (11, 12) comprises a movable counterweight, and the other of the two elements comprises a mount serving as support for the movable counterweight, the two elements and the measurement assembly belonging to a dynamic balancing device.
